# EUROPÄISCHE PATENTANMELDUNG

(11) **EP 1 377 146 A2**
(43) Veröffentlichungstag der Anmeldung: **02.01.2004**
(21) Anmeldenummer: 03007722.6
(22) Anmeldetag: 04.04.2003
(51) Int. Cl.: H05K 3/46, H05K 3/20, H05K 3/00

(54) **Verfahren zur Herstellung eines flächigen Schaltungsträgers**

(30) Priorität: 27.06.2002 DE 10228716
(71) Anmelder: Firma Carl Freudenberg, 69469 Weinheim (DE)
(72) Erfinder: Schenck, Harald, Dr., 69469 Weinheim (DE)

(57) **Zusammenfassung**

Verfahren zur Herstellung eines flächigen Schaltungsträgers, bei dem auf einem Stützkörper zumindest zwei Leiterbilder (3, 3.n) erzeugt werden, wobei als Stützkörper ein Hilfsträger (1) aus einer kontinuierlich ausgebildeten, metallischen Basisfolie einer Dicke von mindest 5 µm verwendet wird, auf die zunächst zumindest eine erste, kontinuierlich ausgebildete Isolierschicht (2) aufgebracht wird und wobei auf die Isolierschicht (2) in der erforderlichen Anzahl abwechselnd jeweils ein Leiterbild (3) und daran nach Bedarf eine kontinuierlich ausgebildete, weitere Isolierschicht (2.n) aufgebracht und festgelegt wird, wonach das so erhaltene Gebilde auf einen flächig ausgebildeten, elektrisch isolierenden Stützkörper (5) auflaminiert wird.

## Beschreibung

Die Erfindung betrifft ein Verfahren zur Herstellung eines flächigen Schaltungsträgers, bei dem auf einem Stützkörper zumindest zwei Leiterbilder erzeugt werden.

### Stand der Technik

Ein solches Verfahren ist bekannt. Die Leiterbilder werden dabei übereinanderliegend auf einem Stützkörper aus polymerem Werkzeug erzeugt, wobei es insbesondere bei feinen Strukturen äußerst schwierig ist, sie zur gegenseitigen Ergänzung miteinander in Verbindung zu bringen. Die elektrische Kapazität eines solchen Schaltungsträgers ist dadurch maßgeblich durch die Größe des Stützkörpers begrenzt. Es entstand daher der Wunsch, die elektrische Kapazität derartiger Schaltungsträger zu erweitern.

### Darstellung der Erfindung

Der Erfindung liegt die Aufgabe zugrunde, das Verfahren der eingangs genannten Art derart weiterzuentwickeln, dass bei einfacher Handhabbarkeit Schaltungsträger mit einer deutlich vergrößerten, elektrischen Kapazität erhalten werden können.

Diese Aufgabe wird erfindungsgemäß bei einem Verfahren der eingangs genannten Art mit den kennzeichnenden Merkmalen von Anspruch 1 gelöst. Auf vorteilhafte Ausgestaltungen nehmen die Unteransprüche Bezug.

Bei dem erfindungsgemäßen Verfahren ist es vorgesehen, dass als Stützkörper ein Hilfsträger aus einer kontinuierlich ausgebildeten, metallischen Basisfolie einer Dicke von zumindest 5 µm verwendet wird, auf die zunächst zumindest eine erste kontinuierlich ausgebildete Isolierschicht aufgebracht wird, dass auf die Isolierschicht in der erforderlichen Anzahl abwechselnd jeweils zumindest ein Leiterbild und nach Bedarf eine kontinuierlich ausgebildete, weitere Isolierschicht aufgebracht wird, wonach das so erhaltene Gebilde auf einen flächig ausgebildeten, elektrisch isolierenden Stützkörper auflaminiert und die Basisfolie gegebenenfalls entfernt wird. Ein wesentliches Merkmal des erfindungsgemäßen Verfahrens besteht somit darin, dass der während dessen Anwendung erforderliche Stützkörper nicht mehr aus polymerem Werkstoff besteht, sondern aus einem Hilfsträger aus einer metallischen Basisfolie einer Dicke von zumindest 5 µm. Derartige Basisfolien bestehen im allgemeinen aus Kupfer. Dies schließt nicht aus, dass gegebenenfalls auch Basisfolien aus anderen Metallen zur Anwendung gelangen können. Je nach Art des verwendeten Metalls beträgt der lineare Wärmeausdehnungskoeffizient weniger als 50 % desjenigen der nach dem Stand der Technik üblicherweise zur Anwendung gelangenden polymeren Werkstoffe. Hierdurch ist es erheblich vereinfacht, die sich während der Durchführung des Verfahrens ergebenden, durch Temperaturwechsel, Zug- und Druckbelastungen sowie die durch chemische Einwirkungen bedingten Dimensionsveränderungen auf kleine Werte zu begrenzen und bleibende Dimensionsveränderungen zu verhindern. Auch bei sehr fein strukturierten Leiterbildern ist es dadurch weitgehend problemlos möglich, diese einander in präziser Weise zuzuordnen und dadurch gegebenenfalls auch ineinander übergehen zu lassen. Die elektrische Kapazität des Schaltungsträgers lässt sich dadurch nach Bedarf vervielfachen.

Für die Dimensionsstabilität des Hilfsträgers ist es von erheblicher Bedeutung, dass die zu seiner Herstellung verwendeten Metalle sich in chemischer Hinsicht wesentlich inerter verhalten als alle polymeren Werkstoffe. Auch die während der Durchführung des Verfahrens auf den Stützkörper einwirkenden Lösungs- oder Ätzmittel bewirken daher im allgemeinen keine Dimensionsveränderungen. Außerdem sind derartige Metallfolien trotz ihrer ausgezeichneten Dimensionsstabilität gut wickelbar, biegbar, zugfest und leicht zu verarbeiten.

Wenn als Hilfsträger eine kontinuierlich ausgebildete, metallische Basisfolie einer Dicke von 10 bis 200 µm verwendet wird, besteht des weiteren die Möglichkeit, die Basisfolie ihrerseits in einem abschließenden Verfahrensschritt in die Gestalt eines weiteren Leiterbildes zu überführen. Dazu vorausgehend wird der flächige Schaltungsträger mit der gegenüberliegenden Seite zunächst auf einen Stützkörper aus polymerem Werkstoff auflaminiert und die Basisfolie anschließend in die Gestalt des letzten Leiterbildes überführt. Dieses kann gegebenenfalls mit den übrigen Leiterbildern in elektrisch leitende Verbindung gebracht werden und diese elektrisch ergänzen. Der gebrauchsfertige Schaltungsträger unterscheidet sich bei einer solchen Ausbildung nicht von den bisher bekannten. Es ist somit weiterhin möglich, einen solchen, aus polymerem Werkstoff bestehenden und in einem abschließenden Arbeitsschritt aufgebrachten Stützkörper als Werbeträger zu verwenden, wie das beispielsweise bei Scheckkarten bekannt und gebräuchlich ist.

Nach einer vorteilhaften Ausgestaltung ist es vorgesehen, dass jeweils zumindest eine Isolierschicht vor der Erzeugung und Aufbringung des nächsten Leiterbildes mit zumindest einer Durchbrechung versehen wird und dass die Durchbrechung bei der Erzeugung und Aufbringung des nächsten Leiterbildes mit einem elektrischen Leiter gefüllt wird, der die beiderseits der Isolierschicht angeordneten Leiterbilder elektrisch leitend miteinander verbindet. Durch die Isolierschicht findet somit eine Durchkontaktierung statt, was es entbehrlich macht, elektrisch leitende Verbindungen im Außenbereich der Leiterbilder vorzusehen, um diese zu verbinden. Hierdurch ist nicht ausgeschlossen, derartige Außenverbindungen, die zumindest eines der Leiterbilder im Außenbereich teilweise umgreifen, ergänzend oder alternativ vorzusehen.

Als besonders zweckmäßig hat es sich erwiesen, wenn die Durchbrechung bei einer derartigen Durchkontaktierung mit dem Werkstoff des das nächste Leiterbild bildenden, elektrischen Leiters ausgefüllt wird. Die Durchführung gestaltet sich in diesem Falle nicht nur besonders einfach, sondern auch besonders funktionssicher hinsichtlich des zu bildenden elektrischen Kontaktes.

Die hierzu erforderliche Durchbrechung kann erzeugt werden, indem auf der vorausgegangenen Isolierschicht eine Abschirmmaske erzeugt und die Isolierschicht nachfolgend an den nicht von der Abschirmmaske bedeckten Stellen vollständig entfernt wird. Letzteres kann beispielsweise unter Anwendung der Lasertechnik erfolgen.

Als vorteilhaft hat es sich bewährt, wenn die Abschirmmaske erzeugt wird, indem zunächst eine kontinuierlich ausgebildete, metallische oder polymere Schicht auf die Isolierschicht aufgebracht wird und wenn die kontinuierliche Schicht nachfolgend durch photolithographische Verfahren und ätztechnische Methoden in die Form der Abschirmmaske überführt wird.

Falls eine kontinuierliche, metallische Schicht zur Anwendung gelangt, genügt eine sehr geringe Schichtdicke, wie beispielsweise durch Aufdampfen eines Metalls auf die Isolierschicht erhältlich. Sie wird nur benötigt, um in der Isolierschicht die erforderlichen Durchbrechungen zu erzeugen. Im Anschluss daran kann sie wegen ihrer besonders geringen Schichtdicke sehr leicht wieder entfernt werden, beispielsweise durch einen weiteren Ätzprozess.

Die Abschirmmaske kann auch durch unmittelbares Aufdrucken und Verfestigen einer abschirmend wirkenden, metallischen und/oder polymeren Substanz auf die abzudeckenden Stellen der Isolierschicht erzeugt werden. Bei einer solchen Durchführungsweise erübrigt es sich, die nicht benötigten Stellen durch Anwendung photolithographischer Verfahren und ätztechnischer Methoden nachfolgend zu entfernen. Es ist jedoch verhältnismäßig schwierig, bei feinen Strukturen die erforderliche Präzision zu erhalten. Bedingt durch die Verwendung einer metallischen Basisfolie als Stützkörper weist das zu bedruckende Bildgebilde jedoch eine große Dimensionsstabilität auf, was es auch bei der Anwendung von drucktechnischen Methoden erleichtert, gute Arbeitsergebnisse zu erzielen.

Auf die erste kontinuierlich ausgebildete Isolierschicht kann in der jeweils erforderlichen Anzahl abwechselnd jeweils zumindest ein Leiterbild und nach Bedarf jeweils eine weitere, kontinuierlich ausgebildete Isolierschicht aufgebracht werden. Auf diese Weise wird insbesondere dann, wenn die einzelnen Leiterbilder ineinander übergehend ausgebildet sind, auf der verfügbaren Fläche des Stützkörpers ein Leiterbild erzeugt, das insgesamt von nahezu beliebiger Größe ist. Beispielsweise in Scheckkartenformate lassen sich auf diese Weise äußerst komplexe Schaltungen und damit auch Funktionen integrieren.

Das schließlich erhaltene Gebilde kann abschließend auf einen flächig ausgebildeten, elektrisch isolierenden Stützkörper auflaminiert werden, beispielsweise auf einen solchen aus Kunststoff, um die Handhabbarkeit zu verbessern und an diejenige der bekannten Scheckkarten anzupassen. Dieses ist nicht unbedingt erforderlich und kann entfallen, wenn eine manuelle Handhabung während des Gebrauchs nicht vorkommt.

Bevorzugt wird ein solcher Stützkörper auf die von der Basisfolie abgewandte Seite auflaminiert, was es erlaubt, die Basisfolie abschließend zumindest teilweise wieder zu entfernen. Sie kann dabei zugleich in die Gestalt eines letzten Leiterbildes überführt werden und die insgesamt bereits vorhandene Schaltung gegebenenfalls ergänzen. Dazu hat es sich als zweckmäßig erwiesen, wenn auf die Basisfolie zur Erzeugung des letzten Leiterbildes eine Abschirmmaske aufgebracht und die Basisfolie an den nicht von der Abschirmmaske bedeckten Stellen zur Bildung des letzten Leiterbildes vollständig entfernt wird. Dabei kann beispielsweise Ätztechnik zur Anwendung gelangen oder andere, einschlägig bekannte Methoden. Abschließend wird das letzte Leiterbild zur Vermeidung von unerwünschten Kurzschlussbrücken mit einer letzten, elektrisch wirksamen Isolierschicht überdeckt.

### Kurzbeschreibung der Zeichnung

Das erfindungsgemäße Verfahren ist in der Zeichnung anhand eines Ausschnittes aus einem längsgeschnittenen Schaltungsträger wiedergegeben und wird nachfolgend näher erläutert.

Es zeigen:

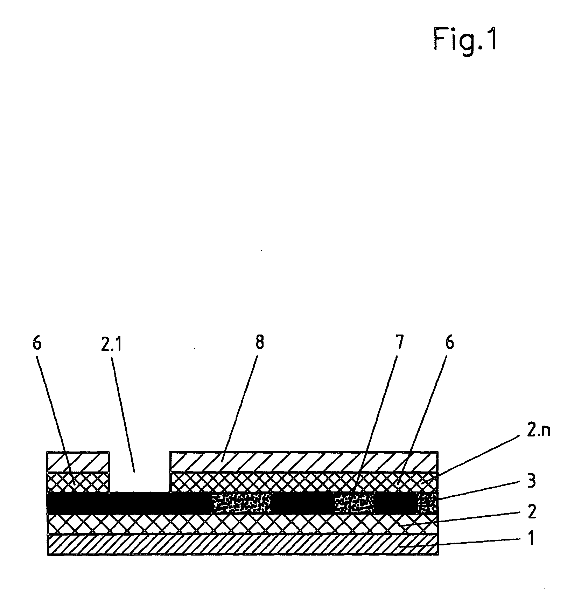

- Fig. 1: Ein erstes Stadium des erfindungsgemäßen Verfahrens anhand eines Leitungsträgers in längsgeschnittener Darstellung. Der Leitungsträger weist einen Hilfsträger 1 aus Metall auf, auf den in mehreren übereinander liegenden Schichten aufgebracht sind eine Isolierschicht 2, ein Leiterbild 3, eine Isolierschicht 2.n und eine Abschirmmaske 8.

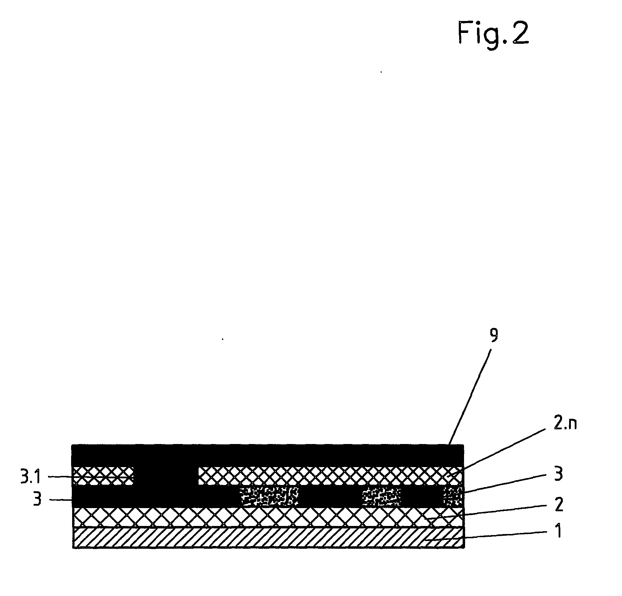

- Fig. 2: Den Schaltungsträger nach Fig. 1 im Anschluss an die vorausgegangene Entfernung der Abschirmmaske 8 und die ersatzweise Aufbringung einer weiteren, kontinuierlichen Schicht 9 aus elektrisch leitendem Werkstoff unter vollständiger Ausfüllung der Durchbrechung 2.1 der Isolierschicht 2.n mit dem elektrisch leitenden Werkstoff zur Erzeugung einer Durchkontaktierung 3.1.
- Fig. 3: Das in Fig. 2 gezeigte Gebilde im Anschluss an die Überführung der Schicht 9 in die Gestalt eines weiteren Leiterbildes 3.n und das nachfolgende Aufkaschieren eines Stützkörpers 5 aus polymerem Werkstoff auf die Oberseite.

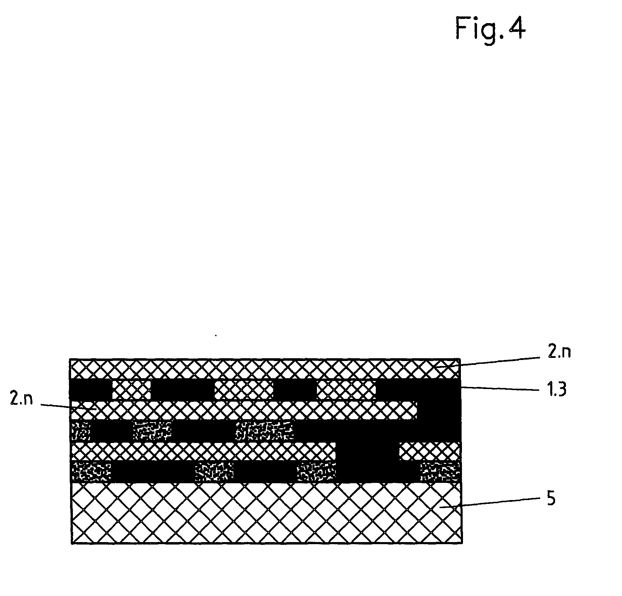

- Fig. 4: Das Gebilde gemäß Fig. 3 im Anschluss an die Überführung des Hilfstützkörpers 1 in die Gestalt eines weiteren Leitungsbildes 1.3 und dem anschließenden Aufbringen einer letzten Isolierschicht 2.n auf dessen frei liegende Oberseite.

### Ausführung der Erfindung

Bei dem erfindungsgemäßen Verfahren gelangt der Stützkörper zunächst als Hilfsträger 1 in Gestalt einer kontinuierlich ausgebildeten, metallischen Basisfolie 1 einer Dicke von bevorzugt 10 bis 200 µm zur Anwendung, bevorzugt in einer Dicke von 20 bis 80 µm. Auf die Oberseite der Basisfolie wird zunächst eine kontinuierlich ausgebildete Isolierschicht 2 aufgebracht und darauf eine kontinuierliche Schicht aus einem elektrischen Leiter, beispielsweise aus Metall. Bevorzugt gelangt für die Schicht Kupfer zur Anwendung. Die Dicke beträgt ebenfalls 10 bis 200 µm, bevorzugt 30 bis 60 µm.

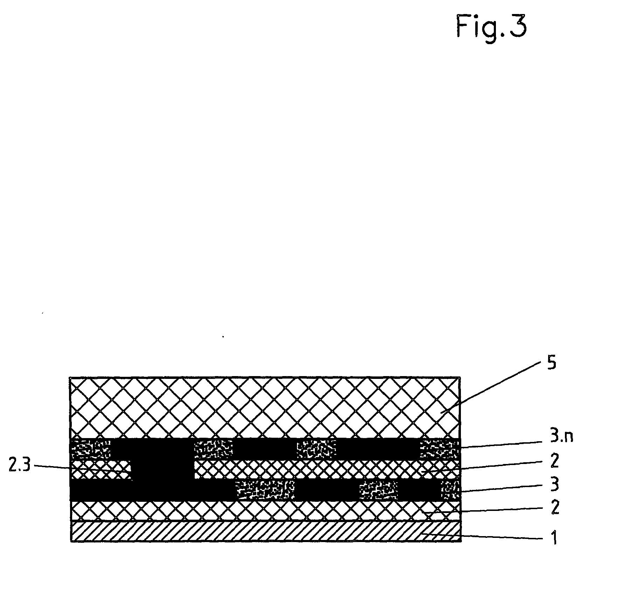

Die Isolierschicht 2 kann vor der Erzeugung und Aufbringung des nächsten Leiterbildes 3.n (Fig. 3) mit zumindest einer Durchbrechung 2.1 versehen werden, wobei die Durchbrechung 2.1 bei der Erzeugung und Aufbringung des nächsten Leiterbildes 3.n mit einem elektrischen Leiter gefüllt wird, der die beiderseits an die Isolierschicht angrenzenden Leiterbilder 3, 3.n elektrisch leitend miteinander verbindet. Dazu wird zur Durchbrechung 2.1 mit dem Werkstoff des das nächste Leiterbild 3.n bildenden, elektrischen Leiters ausgefüllt. Hierbei hat es sich als zweckmäßig erwiesen, wenn die Durchbrechung 2.1 erzeugt wird, indem auf der Isolierschicht 2.n zunächst eine Abschirmmaske 8 erzeugt und die Isolierschicht 2.n nachfolgend an den nicht von der Abschirmmaske 8 bedeckten Stellen vollständig entfernt wird, beispielsweise unter Anwendung der Laser- oder Ätztechnik.

Die Abschirmmaske 8 kann erzeugt werden, indem zunächst eine kontinuierliche, metallische oder polymere Schicht auf die Isolierschicht 2.n aufgebracht wird, wonach die kontinuierliche Schicht durch photolithographische Verfahren und ätztechnische Methoden in die Form der Abschirmmaske 8 überführt wird.

Falls die Isolierschicht unter Anwendung der Lasertechnik entfernt werden soll, genügt es, eine kontinuierliche, metallische Schicht auf der Isolierschicht zu erzeugen, wie beispielsweise durch Aufdampfen eines Metalls erhältlich, beispielsweise von Kupfer. Die Dicke einer derart aufgedampften Schicht kann äußerst gering bemessen sein und beispielsweise 5 bis 10 µm betragen. Sie lässt sich durch die geringe Dicke bei Bedarf sehr leicht entfernen, beispielsweise durch Anwendung der Ätztechnik.

Die Abschirmmaske 8 kann auch durch Aufdrucken und Verfestigen einer abschirmend wirkenden metallischen und/oder polymerem Substanz auf die abzudeckenden Stellen der Isolierschicht 2.n erzeugt werden. Die Anbringung ist technisch besonders einfach durchführbar.

Die Anzahl der im Sinne der vorstehenden Darlegungen auf den Hilfsträger aufgebrachten und gegebenenfalls untereinander verbundenen Leiterbilder ist beliebig. Bedingt durch die große Dimensionsstabilität und dadurch, dass sich der Hilfsträger aufgrund seiner Zusammensetzung aus Metall weitestgehend inert gegenüber der Einwirkung von chemischen Substanzen und physikalischen Belastungen verhält, sind allein funktionelle Erfordernisse des gebrauchsfertigen Schaltungsträgers maßgeblich hierfür.

Auch hinsichtlich der Art der zur Anwendung gelangenden Isolierschichten 2 sind im Rahmen der vorliegenden Erfindung keine besonderen Auflagen zu erfüllen. Die einzelnen Isolierschichten können aus vorgefertigten Folien bestehen, beispielsweise aus Folien aus polymerem Werkstoffen, welche unter Verwendung eines sekundären Klebers nach Bedarf mit der bereits vorliegenden Unterlage verklebt werden. Es besteht auch die Möglichkeit, elektrisch isolierende Folien aus polymeren Werkstoffen zu verwenden und in thermoplastisch erweichtem Zustand mit der jeweiligen Unterlage zu verkleben. Des weiteren ist es möglich, einen entsprechenden, elektrisch isolierenden, polymeren Werkstoff in erweichtem Zustand unmittelbar auf die Oberfläche aufzubringen und im Zuge der nachfolgenden Verfestigung mit der Unterlage zu verkleben, beispielsweise im Zuge der Erkaltung.

Ausgehend vom späteren Gebrauch ist es häufig erwünscht, dass der flächige Schaltungsträger abschließend mit einem Stützkörper aus polymerem Werkstoff verbunden wird, beispielsweise mit einem Stützkörper in Gestalt einer biegesteifen Platte. Als bevorzugter Werkstoff gelangt diesbezüglich ..... zur Anwendung. Zweckmäßig wird ein solcher Stützkörper mit der von der Basisfolie 1 abgewandten Seite des Schaltungsträgers verbunden. Auch dabei können die vorstehend beschriebenen Laminiertechniken zur Anwendung gelangen, d.h. der Stützkörper 5 kann aus einer vorgefertigten Folie bestehen, die entweder durch thermoplastische Erweichung oder durch Verwendung eines sekundären Klebstoffes mit dem Gebilde verbunden wird. Alternativ besteht auch die Möglichkeit, gegebenenfalls einen zuvor erweichten, polymeren Werkstoff unmittelbar auf das Gebilde aufzubringen und im Zuge seiner Formgebung und Verfestigung damit zu verbinden.

Die gegenüberliegende Seite ist zu diesem Zeitpunkt immer noch mit dem Hilfsträger 1 aus einer Basisfolie aus Metall versehen. Diese kann abschließend zumindest teilweise entfernt werden. Es besteht dabei insbesondere die Möglichkeit, die Basisfolie auch ihrerseits in die Gestalt eines letzten Leiterbildes 1.3 zu überführen und in die Gesamtschaltung zu integrieren. Hierbei hat es sich als zweckmäßig erwiesen, wenn auf die Basisfolie zur Erzeugung des letzten Leiterbildes 1.3 eine Abschirmmaske 8 aufgebracht und die Basisfolie an den nicht von der Abschirmmaske 8 bedeckten Stellen zur Bildung des letzten Leiterbildes 1.3 vollständig entfernt wird. Auch dabei können wiederum Ätz- oder Lasertechniken zur Anwendung gelangen. Um während des späteren Gebrauches eine unerwünschte Kurzschlussbrückenbildung in dem nunmehr ungeschützten, letzten Leiterbild zu vermeiden, hat es sich als zweckmäßig erwiesen, es abschließend mit einer letzten Isolierschicht 2.n zu überdecken. Zweckmäßig gelangt auch diesbezüglich eine elektrisch isolierende, kratzfeste Schicht aus einem polymeren Werkstoff zur Anwendung, beispielsweise aus ABS. Diese Schicht läßt sich gegebenenfalls ebenfalls als Werbeträger verwenden.

## Patentansprüche

1. Verfahren zur Herstellung eines flächigen Schaltungsträgers, bei dem auf einem Stützkörper zumindest zwei Leiterbilder erzeugt werden, **dadurch gekennzeichnet, dass** als Stützkörper ein Hilfsträger (1) aus einer kontinuierlich ausgebildeten, metallischen Basisfolie einer Dicke von mindest 5 µm verwendet wird, auf die zunächst zumindest eine erste, kontinuierlich ausgebildete Isolierschicht (2) aufgebracht wird, dass auf die Isolierschicht (2) in der erforderlichen Anzahl abwechselnd jeweils ein Leiterbild (3) und daran nach Bedarf eine kontinuierlich ausgebildete, weitere Isolierschicht (2.n) aufgebracht und festgelegt wird, wonach das so erhaltene Gebilde auf einen flächig ausgebildeten, elektrisch isolierenden Stützkörper (5) auflaminiert wird.

2. Verfahren nach Anspruch 1 oder 2, **dadurch gekennzeichnet, dass** eine Basisfolie einer Dicke von 10 bis 200 µm verwendet wird.

3. Verfahren nach einem der Ansprüche 1 oder 2, **dadurch gekennzeichnet, dass** zumindest eine Isolierschicht (2, 2.n) vor dem Aufbringen des nächsten Leiterbildes (3, 3.n) mit zumindest einer Durchbrechung (2.1) versehen wird und dass die Durchbrechung bei der Erzeugung des nächsten Leiterbildes (3.n) mit einem elektrischen Leiter (3.1) ausgefüllt wird, der die beiderseits der Isolierschicht angeordneten Leiterbilder (3, 3.n) elektrisch leitend verbindet.

4. Verfahren nach Anspruch 3, **dadurch gekennzeichnet, dass** die Durchbrechung (2.1) mit dem das nächste Leiterbild (3.n) bildenden, elektrischen Leiterwerkstoff zur Erzeugung einer Durchkontaktierung (3.1) ausgefüllt wird.

5. Verfahren nach Anspruch 3 oder 4, **dadurch gekennzeichnet, dass** die Durchbrechung (2.1) erzeugt wird, indem auf der Isolierschicht (2, 2.n) eine Abschirmmaske (8) erzeugt und die Isolierschicht (2, 2.n) nachfolgend an den nicht von der Abschirmmaske 8 bedeckten Stellen vollständig entfernt wird.

6. Verfahren nach Anspruch 3 oder 4, **dadurch gekennzeichnet, dass** die Abschirmmaske (8) erzeugt wird, indem zunächst eine kontinuierliche metallische oder polymere Schicht auf die Isolierschicht (2, 2.n) aufgebracht und dass die kontinuierliche Schicht nachfolgend durch photolithographische Verfahren und ätztechnische Methoden in die Form der Abschirmmaske (8) überführt wird.

7. Verfahren nach Anspruch 6, **dadurch gekennzeichnet, dass** eine kontinuierliche, metallische Schicht durch Aufdampfen eines Metalls auf die Isolierschicht (2, 2.n) erzeugt wird.

8. Verfahren nach Anspruch 3 oder 4, **dadurch gekennzeichnet, dass** die Abschirmmaske (8) durch unmittelbares Aufdrucken und Verfestigen einer abschirmend wirkenden, metallischen und/oder polymeren Substanz auf die abzudeckenden Stellen der Isolierschicht (2, 2.n) erzeugt wird.

9. Verfahren nach einem der Ansprüche 1 bis 8, **dadurch gekennzeichnet, dass** das Gebilde mit der von dem Hilfsträger (1) abgewandten Seite auf den Stützkörper (5) auflaminiert wird.

10. Verfahren nach Anspruch 9, **dadurch gekennzeichnet, dass** der Hilfsträger (1) abschließend zumindest teilweise entfernt wird.

11. Verfahren nach Anspruch 10, **dadurch gekennzeichnet, dass** der Hilfsträger (1) abschließend teilweise entfernt und in die Gestalt eines letzten Leiterbildes (3.n) überführt wird.

12. Verfahren nach Anspruch 11, **dadurch gekennzeichnet, dass** auf den Hilfsträger (1) eine Abschirmmaske (4) aufgebracht und der Hilfsträger (1) an den nicht von der Abschirmmaske (4) bedeckten Stellen zur Bildung eines letzten Leiterbildes (3.1) vollständig entfernt wird.

13. Verfahren nach Anspruch 12, **dadurch gekennzeichnet, dass** das letzte Leiterbild (3.1) abschließend mit einer letzten Isolierschicht (2.n) überdeckt wird.
